Europäisches Patentamt

European Patent Office

Office européen des brevets

(19)

(11) Veröffentlichungsnummer: **0 069 790**
**B1**

(12) **EUROPÄISCHE PATENTSCHRIFT**

(45) Veröffentlichungstag der Patentschrift: **26.06.85**

(21) Anmeldenummer: **81105399.0**

(22) Anmeldetag: **10.07.81**

(51) Int. Cl.⁴: **G 01 R 31/08**

(54) **Verfahren und Gerät zur Erdschlussortung an Starkstrom-Freileitungsnetzen.**

(43) Veröffentlichungstag der Anmeldung:
**19.01.83 Patentblatt 83/03**

(45) Bekanntmachung des Hinweises auf die
Patenterteilung:
**26.06.85 Patentblatt 85/26**

(84) Benannte Vertragsstaaten:
**BE CH IT LI LU NL SE**

(56) Entgegenhaltungen:
**AT-B- 188 395**
**DE-A-1 791 017**
**DE-B-1 231 808**
**DE-B-2 226 743**
**DE-C- 902 158**
**DE-C- 955 348**

**ARCHIV FÜR TECHNISCHES MESSEN, V
35194-1 bis V 35194-7
Elektrie, H8, 1969, S. U131**

**Die Akte enthält technische Angaben, die nach
dem Eingang der Anmeldung eingereicht
wurden und die nicht in dieser Patentschrift
enthalten sind.**

(73) Patentinhaber: **Prause, Jozsef, Dipl.-Ing.**
**Füleki u. 18**
**H-2013 Pomáz (HU)**
(73) Patentinhaber: **Domokos, Gyözö, Dipl.-Ing.**
**Báthori u. 17**
**H-2330 Dunaharaszti (HU)**
(73) Patentinhaber: **Bely, András, Dipl.-Ing.**
**Latinka S.u. 36**
**H-1116 Budapest (HU)**

(72) Erfinder: **Prause, Jozsef, Dipl.-Ing.**
**Füleki u. 18**
**H-2013 Pomáz (HU)**
Erfinder: **Domokos, Gyözö, Dipl.-Ing.**
**Báthori u. 17**
**H-2330 Dunaharaszti (HU)**
Erfinder: **Bely, András, Dipl.-Ing.**
**Latinka S.u. 36**
**H-1116 Budapest (HU)**

(74) Vertreter: **Patentanwälte Viering & Jentschura**
**Steinsdorfstrasse 6**
**D-8000 München 22 (DE)**

EP 0 069 790 B1

## Beschreibung

Die Erfindung betrifft ein Verfahren und ein Gerät zur Erdschlußortung an Starkstrom-Freileitungsnetzen.

Die Lokalisierung der Erdschlüsse in Starkstrom-Freileitungsnetzen, insbesondere in kompensierten radialen Mittelspannungs-Freileitungsnutzen, ist eine zeitaufwendige Arbeit. Wird in unkompensierten Netzen ein Erdschluß bemerkt, so muß das Netz spannungsfrei gemacht, und der Fehler entweder durch Abgehen des Netzes gesucht oder, wie z.B. in der SU—A—287 185 vorgeschlagen, durch Abgleichen eines in Brückenschaltung arbeitenden Gerätes ungefähr eingegrenzt werden. In dem eingegrenzten Abschnitt muß der Fehler dann durch Abgehen des Netzes gefunden werden. In beiden Fällen ist die Ortung der Erdschlußstelle auch in leichterem, z.B. ebenem Gelände eine sehr zeitaufwendige und langwierige Aufgabe, die im letzteren Falle auch spezielle Meßgeräte erfordert und auf jeden Fall mit Unterbrechnungen der kontinuierlichen Versorgung verbunden ist, was bei den Verbrauchern Schwierigkeiten verursachen kann.

Im Falle kompensierter Netze ist es durch die zwischen die Speiseklemmen geschaltete kompensierende Wicklung möglich, bei Eintreten eines Erdschlusses den Betrieb des Netzes noch eine gewisse Zeit lang aufrechtzuerhalten; jedoch muß auch in diesem Fall der Fehler so schnell wie möglich geortet werden. Bei kompensierten Netzen ist es üblich, das Netz vom Speisepunkt ausgehend mittels an den Masten befindlicher Schalter abschnittsweise zu unterbrechen und auf diese Weise den Fehler einzugrenzen. Für dieses Vorgehen ist es jedoch erforderlich, daß zwischen den das Netz untersuchenden Personen und dem sich am Speisepunkt aufhaltenden Personal eine Informationsverbindung besteht, damit die zur Überprüfung des Netzes notwendige Unterbrechung und Erregung sowie die Kontrolle des Netzabschnittes mit Meßgeräten koordiniert vorgenommen werden kann. In dieser Zeit haben die Verbraucher keinen Strom, und in ungünstigen Fällen kann der Erdschluß nur nach mehrmaligem Abschalten geortet werden. Das Verfahren ist darüber hinaus—weil die Masten manchmal schwer zugänglich sind und die hoch oben an den Masten angebrachten Isolatoren geprüft bzw. aus Sicherheitsgründen ausgewechselt werden müssen—sehr zeitraubend, die Lebensdauer der Schalter und Unterbrecher ist geringer, die Betätigung der Schalter kann gefährlich sein, das Zusammenwirken mehrerer Schaltberechtigter ist erforderlich, ferner ein Fahrzeug sowie eine Informationsverbindung, z.B. über Funk.

Bekannt sind ferner Geräte zur Ortung von Erdschlüssen oder Leitungsunterbrechungen (GB—A—1 374 700). Diese Geräte werden in bestimmten Abständen voneinander in der Nähe der Leitung oder am Boden nahe der Leitung angebracht; im Falle von Erdschluß oder Unterbrechung ändert sich der Phasenstrom bzw. das von ihm erregte magnetische Feld beträchtlich, und die Geräte zeigen diese Änderung durch Signale (z.B. die Änderung der Stellung eines Hebels) an. Bei der genaueren Ortung der Fehlerstelle gibt der letzte unveränderte (oder der letzte veränderte) Signalhebel einen Hinweis. Nachteilig ist, daß verhältnismäßig viel Geräte angebracht werden müssen, deren Herstellung, Einbau in die Fernleitung, Rückstellen in die Ausgangsstellung und Instandhaltung einesteils kostenaufwendig ist, andernteils ermüdende, unfallgefährliche Arbeit auf dem Mast erfordert.

Aus der GB—A—1 360 469 ist ein Fehlerortungsgerät bekannt, das auf der Messung von Feldstärkeänderungen beruht. Das Gerät enthält, aufeinanderfolgend angeordnet, einen Meßfühler für magnetfelder, z.B. eine Spule mit Ferritkern, einen Verstärker, einen Empfindlichkeitsregler, einen Zweizustands-Schaltstromkreis und dessen jeweiligen Zustand anzeigende Organe. Mit dem Gerät wird entlang der ein- oder dreiphasigen Fernlietung das von der Phase (den Phasen) erzeugt Feld oder das resultierende Feld an der Stelle seiner geringsten Stärke untersucht. Die Anzeige bleibt so lange unverändert, wie die Stärke des resultierenden magnetischen Feldes unter dem an dem Gerät eingestellten Empfindlichkeitswert bleibt. Ist das Netz schadhaft, so ändert sich das magnetische Feld oder dessen Resultierende, was von dem Meßfühler wahrgenommen wird und zum Kippen des Zweizustands-Schaltstromkreises und einer dementsprechenden Anzeige führt. Zwischen dem Meßfühler und dem Verstärker des Gerätes ist eine Verzögerungsorgan, z.B. ein Kondensator, angebracht, der die Aufgabe hat, die Wirkung der Fallweise auftretenden Transienten-Phasenströme zu beseitigen; der Schaltstromkreis verfügt über eine automatische Rückstellung, die—wenn der Fehler beseitigt wurde—dessen Anzeige nach einer gewissen Zeit löscht.

Der wesentlichste Nachteil dieses Gerätes besteht darin, daß es für kompensierte Netze nur begrenzt einsetzbar ist, da im Netz der das resultierende magnetische Feld am meisten bestimmende Faktor, die Grundschwingung, in Bezug auf Erdschlüsse kompensiert ist. Da das Gerät für magnetische Felder empfindlich ist, die von den Betriebsstrom im allgemeinen um Größenordnungen übersteigenden Fehlerströmen hervorgerufen werden, ist es zur Wahrnehmung der infolge der Kompensation um mehrere Größenordnungen geringeren Erdschlußströme praktisch ungeeignet. Wird seine Empfindlichkeit auf die Wahrnehmung der kompensierten Erschlußströme eingestellt, so zeigt das Gerät auch das von dem normalen Betriebsstrom erregte magnetische Feld als Leitungsfehler an.

Natürlich kommt es auch vor, daß das magnetische Feld nicht genau an der Stelle seines kleinsten Wertes untersucht wird; in diesem Falle wertet das Gerät den abgefühlten Wert der Feldstärke irrtümlich als Fehler. Dies zu korrigieren erfordert weitere Messungen. Schließlich ist es die Sache einer subjektiven Entscheidung, ob man die Fehleranzeige akzeptiert oder nicht.

Das Gerät pat weiter den Nachteil, daß mit ihm nur die Tatsache festgestellt werden kann, daß der Fehler besteht. Um die Fehlerstelle zu lokalisieren, muß der Betrieb der Leitung mehrmals unterbrochen werden, oder es müssen auf die im Zusammenhang mit der GB—A— 1 374 700 beschriebene Weise mehrere Geräte angebracht werden.

Ferner sind Ausführungsformen bekannt, gemäß denen das von dem geringen Erdschlußstrom der Leitung hervorgerufene Magnetfeld gemessen und aus seiner Größe auf den Ort des Fehlers geschlossen wird. Bei kompensierten Netzen geben diese Methoden jedoch kein zuverlässiges Ergebnis, da einesteils die Energieunternehmen aus geschäftlichen Gründen bestrebt sind, durch die Kompensation den Erdschlußreststrom so niedrig wie möglich zu halten, weswegen zwischen dem Feld, das von dem in einer erdschlüssigen Abzweigung fließenden Strom induziert ist, und dem Feld, das in der an den gleichen Speisepunkt angeschlossenen fehlerfreien Leitung fließenden Strom induziert ist, kein wesentlicher Unterschied besteht, und andernteils am Ort der Messung die Parameter des magnetischen Feldes z.B. von der Masthöhe beeinflußt werden. Außerdem kann die resultierende Erregung der Betriebsströme des vom Meßpunkt in asymmetrischer Entfernung befindlichen Dreiphasensystems ein die Messung schädlich beeinflussendes magnetisches Feld erzeugen, und schließlich induziert—wenn die auf der Erde bezogene Kapazität der fehlerfreien Leitung verhältnismäßig groß ist—der kapazitive Strom der unsymmetrischen Spannungsverteilung ein die Messung nachteilig beeinflussendes magnetisches Feld, wodurch das Erkennen des erdschlüssigen Zweigs unsicher wird.

Es sind gemäß den einleitenden Teilen der Ansprüche 1, 3 und 4 auch ein Verfahren und ein Gerät bekannt (Zeitschrift "Elektrie", Heft 8, 1969, S. U131), bei welchem davon Gebrauch gemacht wird, daß der Oberwellenanteil des Erdschlußstromes in der fehlerhaften Leitung stets größer ist als in einer ungestörten Leitung, und der Oberwellenanteil nach der Erdschlußstelle hin merklich geringer wird. Mit dem bekannten Gerät wird daher der Oberwellenanteil in der Leitung an mehreren Stellen gemessen, und aus diesen Messungen wird die Stelle des Erdschlusses ermittelt. Die Messung der Oberwelle erfolgt mit einem magnetischen Meßfühler, der über einen Zwischenverstärker und eine die Grundschwingung des Magnetfeldes ausfilterndes Filter an das Gerät angeschlossen ist und mittels eines Umschalters und Kondensatoren auf die zu prüfende Oberwelle abgestimmt werden kann. Das transportable Gerät ist zur Ermittlung des in einer Phase eines isolierten oder kompensierten Netzes mit einer Spannung von 6 bis 20 kV entstandenen Erdschlusses vorgesehen. Mit dem bekannten Gerät wird die der Relativstellung des Meßfühlers zu der zu überprüfenden Leitung entsprechende Komponente der Feldstärke im Meßpunkt gemessen. Eine solche Messung ist daher abhängig von der Relativlage des Meßpunktes, d.i. abhängig davon, ob die Messung über, unter oder seitlich der Leitung erfolgt, von der Form des von der Leitung erregten Magnetfeldes, das durch die Nähe von beispielsweise Eisenbahnschienen verzerrt sein kann, von der Lage der Wicklung des Meßfühlers zu dem magnetischen Feld sowie von der augenblicklichen Stromstärke der ausgewählten Oberschwingung des Leitungsstromes bzw. des Erdschlußstromes. Diese Stromstärke kann sich in gewissen Fällen zeitlich ändern. Außerdem kann nach diesem bekannten Verfahren nicht stets eindeutig auf den erdschlüssigen Leitungsabschnitt geschlossen werden, weil aus der Größe des gemessenen Wertes nicht von selbst bestimmt werden kann, ob dieser Wert im Zeitpunkt der Messung den fehlerfreien oder den erdschlüssigen Zustand der Leitung charakterisiert und weil beim Feststellen einer Meßabweichung in zwei aufeinanderfolgenden Messungen nicht immer eindeutig festgestellt werden kann, ob sich diese Abweichung aus dem Vorhandensein eines Erdschlusses in dem Abschnitt zwischen den beiden Meßpunkten ergibt, oder aus den Schwankungen des Kurzschlußstromes folgt. Ferner kann mit dem bekannten Verfahren die erdschlüssige Leitung auch nicht eindeutig festgestellt werden, wenn eine fehlerfreie, jedoch starke Oberschwingungen erzeugende Leitung in der Nähe verläuft, wodurch es möglich ist, daß die fehlerfreie Leitung irrtümlich als erdschlüssig festgestellt wird. Die gleiche Irrtumsgefahr besteht bei Leitungsabweigungen, wenn der eine Leitungszweig erdschlüssig ist, an den anderen jedoch Verbraucher angeschlossen sind, durch die starken Oberschwingungen erzeugt werden.

Durch die Erfindung wird die Aufgabe gelöst, das Verfahren der im einleitenden Teil des Anspruchs 1 angegebenen Art und das Gerät der in den einleitenden Teilen der Ansprüche 3 und 4 angegebenen Art derart auszugestalten, daß die fehlerhafte Leitung und die Stelle des Erdschlusses bei kompensierten wie auch unkompensierten Freileitungsnetzen zuverlässig bestimmt werden können.

Dies wird gemäß der Erfindung durch die Merkmale aus dem kennzeichnenden Teil des Anspruchs 1 bzw. jeweils der Ansprüche 3 und 4 erreicht.

Eine Weiterbildung des erfindungsgemäßen Verfahrens ist im Anspruch 2 angegeben. Bevorzugt Ausgestaltungen des erfindungsgemäßen Gerätes sind Gegenstand jeweils der Ansprüche 5 bis 8.

Zum Orten eines Fehlers in einer Leitung, insbesondere in einem Kabel, ist es an sich bekannt (DE—A—1 791 027), zwei Meßfühler zur Aufnahme des Magnetfeldes, welches durch den in die Leitung eingespeisten Wechselstrom induziert wird, zum Orten eines Leitungsfehlers durch Feststellen der Änderung des Phasenwinkels des Wechselstroms am Fehlerort zu verwerden und die Ausgangssignale der Meßfühler zu verstärken. Ferner ist es zum Feststellen des Fehlerortes von unterirdischen Kabelnetzen bekannt (DE—B—2 226 743), zwei Meßfühler zu verwenden, an denen je ein Gleichrichter mit nachgeschalteter Anzeigeeinheit angeschlossen ist. Nach einem anderen bekannten Vorschlag (AT—A—188 395) zum Orten von Kurzschlußstellen an unterirdischen Kabelnetzen wird ein Meßfühler verwendet, der mittels eines Vorfiltergliedes so ausgelegt ist, daß nur die verwendete Meßfrequenz durchgelassen wird.

Die Erfindung macht ebenfalls davon Gebrauch, daß sich die von gewissen Oberschwingungsströmen eines Starkstrom-Freileitungsnetzes hervorgerufene Erregung im Falle eines Erdschlusses wesentlich ändert. In einem dreiphasigen Netz bilden bei störungsfreiem Betrieb die Lastströme ein annähernd symmetrisches System, erzeugen in der Nähe der Phasenleiter ein Drehfeld, und dessen Größe oder die Größe zweier beliebiger Komponenten dieses Feldes ist meßbar. Darüber hinaus jedoch macht die Erfindung von der durch Messungen gewonnenen Erkenntnis Gebrauch, daß bei störungsfreiem Betrieb der Wert der vertikalen Komponente des von den Oberschwingungsströmen erregten Feldes größer als oder annähernd gleich dem Wert der waagerechten Komponente ist und daß bei Erdschluß sich die Komponenten des von den Oberschwingungen erzeugten Feldes derart ändern, faß die waagerechte Komponente unter der erdschlüssigen Leitung am stärksten abweicht.

Diese Erscheinung tritt bei mit Erdschlußkompensation versehenen Netzen verstärkt auf, und zwar deswegen, weil die Erdschlußkompensation meistens auf die Grundschwingung dimensioniert und daher für einzelne Oberschwingungen praktisch schon wirkungslos ist. Die Stelle des Erdschlusses kann sicherer bestimmt werden, wenn man die erwähnten Messungen an einem Feld vornimmt, das durch eine vorher ausgewählte, unkompensierte Oberschwingung erregt wird, für die die Erdschlußkompensation als wirkungslos zu betrachten ist. Abhängend von den Gegebenheiten des Netzes sind die geeigneten Oberschwingungen meistens die ungeradzahligen, z.B. die fünfte, siebente oder neunte Oberschwingung.

Wie eigene Messungen außerdem erweisen haben, ändert sich in der Nähe der Stelle des Erdschlusses der Wert der waagerechten Komponente sprunghaft. Auf diese Weise kann durch Messung der Größe der waagerechten Komponente und des Verhältnisses der Komponenten des von der ausgewählten Oberschwingung erregten Felds ie Stelle des Erdschlusses auf einen Meter genau gemessen werden.

Bei der Ausgestaltung des erfindungsgemäßen Gerätes wurd berücksichtigt, daß Größe und Verhältnis der Oberschwingungskomponenten eines ausgewählten Feldes zweckmäßigerweise so gemessen werden können, daß man die die Messung störende Grundschwingung und die restlichen Oberschwingungen ausfiltert, eine der Größe der Komponenten der ausgewählten Oberschwingung proportionales Gleichspannungssignal herstellt, und den Vergleich der Größe der Komponenten durch Umwandlung des Gleichspannungssignals und durch seine Verarbeitung bzw. Sichtbarmachung vornimmt.

Das Gerät nimmt, wenn es in eine geeignete Stellung gebracht wird, die miteinander im Raum einen Winkel einschließenden Komponenten des vom Netz erzeugten Feldspektrums getrennt voneinander auf. Bei der sich aus dem Anspruch 3 ergebenden ersten Variante des erfindungsgemäßen Geräts wird einesteils der zu der einen Komponente proprtionale Gleichspannungspegel angezeigt, und andernteils wird das Verhältnis (der Quotient) der zu den einzelnen Komponenten proportional Gleichspannungspegel gebildet und ebenfalls angezeigt. Bei der anderen Variante des Gerätes gemäß Anspruch 4 wird der Verstärkungsfaktor der einen Komponente proportionalen Gleichspannungspegel so geändert, daß der eine Gleichspannungspegel als Einheitspegel, der andere in dessen Einheiten ausgedrückt angezeigt wird.

In der bevorzugten Ausführungsform des Meßfühlers also induktiver Meßfühler kann dieser z.B. eine Spule mit Eisenkern, Luftkern oder Ferritkern, oder z.B. ein Hall-Generator sein. Der induktive Meßfühler ist zweickmäßig gegen das elektrische Feld abgeschirmt.

Mit Hilfe des erfindungsgemäßen Verfahrens und des erfindungsgemäßen Gerätes ist es möglich, in mit Erdschlußkompensation versehenen oder isolierten Freileitungsnetzen den Erdschluß viel einfacher, leichter und schneller zu finden als mit den bekannten Verfahren. Zur Lokalisierung des Fehlers ist es ausreichend, entlang der Linienführung des Netzes stellenweise, z.B. an Kreuzungen des Straßennetzes, die Größe einer bestimmten Oberschwingung des von dem Netz erregten Magnetfeldes und das Verhältnis de Komponenten dieser Oberschwingung zu messen. In dem eingekreisten Abschnitt wird weiter gemessen, und aus den gemessenen Werten und deren Verhältnis ergibt sich die Fehlerstelle mit einer Genauigkeit von einem Meter. Weiterhin ist es vorteilhaft, daß der Fehler an dem fraglichen Mast geortet wird, d.h. daß es nicht erforderlich ist, im Falle verborgener Fehler auf den Mast zu den oben angebrachten Isolatoren zu steigen und eventuell intakte Isolatoren grundlos auszuwechseln.

Das erfindungsgemäße Gerät ist klein, leicht, tragbar, und seine Benutzung erfordert keine speziellen Fachkenntnisse.

Die Erfindung wird im folgenden anhand von zwei bevorzugten Ausführungsbespielen mit Hilfe der Zeichnung näher erläutert. In beiden Fällen sind die Meßfühler induktive Meßfühler.

Fig. 1 zeigt das Blockschema des Gerätes gemäß der ersten Variante der Erfindung, und

Fig. 2 stellt das Blockschema des Gerätes gemäß der zweiten Variante der Erfindung dar.

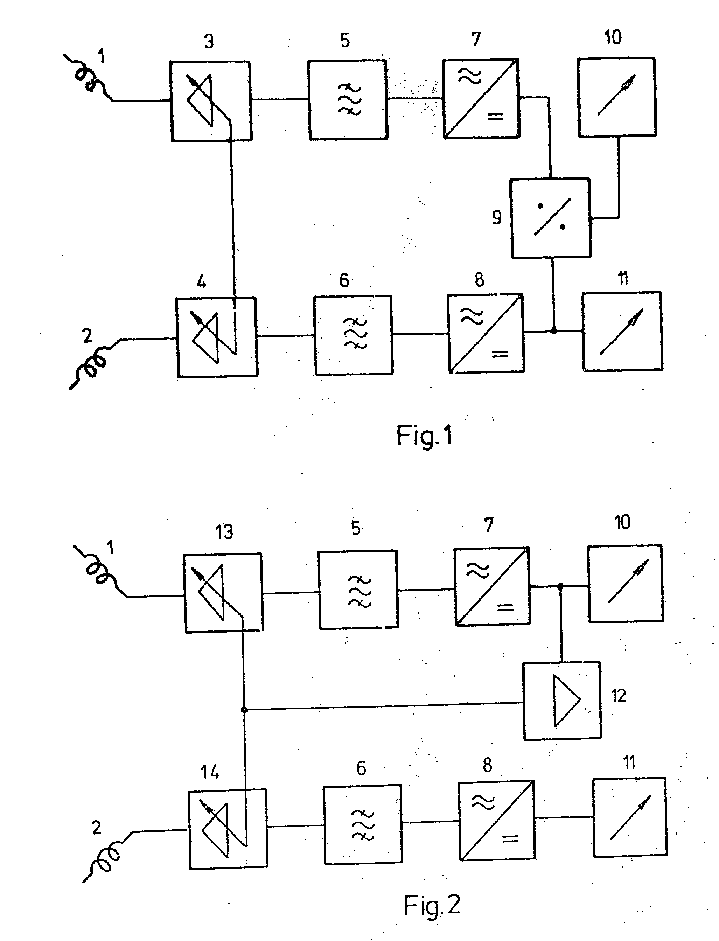

Die in Fig. 1 dargestellte Variante des Gerätes besteht aus induktiven Meßfühlern 1, 2, ferner Verstärkern 3, 4, Filtern 5, 6, Gleichrichtern 7, 8 sowie einer quotientenbildenden Einheit 9 und Anzeigeeinheiten 10, 11.

Der induktive Meßfühler 1 bildet mit dem über ein Vorfilterglied angeschlossenen Verstärker 3 und dem mit diesen in Reihe geschalteten Filter 5 und Gleichrichter 7 eine die Weiterleitung und Verarbeitung des Signales gewährleistende Reihe, die von der durch den induktiven Meßfühler 2, dem sich über ein zweites Vorfilterglied an diesen anschließenden Verstärker 4 und dem mit diesen in Reihe geschalteten Filter 6 und Gleichrichter 8 gebildeten Reihe völlig unabhängig ist.

Die induktiven Meßfühler haben eine hohe Induktivität; zweckmäßigerweise sind sie Wicklungen mit Eisen- oder Ferritkern. Die beiden induktiven Meßfühler 1, 2 sind so angeordnet, daß sie bzw. die Achsen der Wicklungen einen Winkel von 90° einschließen. Die Wicklungen sind gegen ein elektrisches Feld abgeschirmt.

Die induktiven Meßfühler 1, 2 yind mit ihrem Ausgang unter Zwischenschaltung eines nicht dargestellten kapazitiven Elementes, z.B. eines Kondensators, mit dem Verstärker 3 bzw. 4 verbunden.

Das kapazitive Element und seine Anordnung werden so gewählt, daß das kapazitive Element ein die Frequenz der Grundschwingung ausschließendes Vorfilterglied bildet.

Die Verstärker 3 bzw. 4 haben eine hohe Eingangsimpendanz, einen breiten Aussteuerbereich und eine geringe Verzerrung. Der Verstärkungsfaktor der Verstärker 3 und 4 stimmt überein und kann—zweckmäßigerweise von Hand—verstellt werden. Die Verstärker 3 und 4 können, um die den unerwünschten Frequenzen proportionalen Signale besser auszufiltern, mit Bandsperren versehen sein. Die Verstärker 3 und 4 können auch als einziger Mehrkanalverstärker ausgeführt sein.

Der Ausgang des Verstärkers 3 ist an den Eingang des Filters 5, der Ausgang des Verstärkers 4 an den Eingang des Filters 6 angeschlossen. Die Filter 5 und 6 sind aktive Filter; sie sind mit einem Doppel-T-Glied oder einer mehrfachen Rückkopplung sowie mit Temperaturkompensation versehen. Ihre Betriebsfrequenz ist auf die Frequenz der zu messenden Oberschwingung des Feldes eingestellt, und zwar mit einer Bereichsbreite, die auch die sich aus den Frequenzschwankungen ergebenden Änderungen erfaßt. Die filter 5 und 6 können auch als ein einziges Mehrkanalfilter ausgeführt sein.

Der Ausgang des Filters 5 ist an den Eingang des Gleichrichters 7, der Ausgang des Filters 6 an den Gleichrichter 8 angeschlossen. Die Gleichrichter sind Signalwandler mit hoher Linearität und kleinem Unempfindlichkeitsbereich.

Die die von den einzelnen Komponenten erzeugten Signale vorfilternden, verstärkenden, filternden und zu einem Gleichspannungssignal formenden Stufen sind so ausgebildet, daß sie in dem bestimmten Frequenzbereich für Komponenten der gleichen Feldstärke eine Ausgangsgleichspannung gleicher Größe liefern.

Der Ausgang des Gleichrichters 7 ist mit dem einen Eingang der quotientenbildenden Einheit 9 verbunden, während der Ausgang des Gleichrichters 8 verzweigt ist und der eine Zweig mit dem anderen Eingang der quotientenbildenden Einheit 9 verbunden ist.

Die quotientenbildende Einheit 9 vergleicht die Ausgangssignale der Gleichrichter 7 und 8 miteinander, und ihr Ausgangssignal, das an der mit ihrem (der quotientenbildenden Einheit 9) Ausgang verbundenen Anzeigeeinheit 10 erscheint, ist zu dem Verhältnis der Eingangssignale proportional. Die quotientenbildende Einheit 9 ist zweckmäßigerweise so ausgebildet, daß die Proportionen der Verhältnisbildung variiert werden können.

Der andere Ausgangsweig des Gleichrichters 8 ist mit der angeren Anzeigeeinheit 11 verbunden. Die Anzeigeeinheiten 10 und 11 haben zweckmäßigerweise Signalwandler und mit deren Ausgang verbundene LED-Anzeiguglieder. Die Signalwandler schalten eine der Größe der Feldkomponente entsprechende Anzahl LED oder (wenn den Spannungswerten an der Anzeigeeinheit definierte Orte zugeordnet sind) eine an der der Größe der Feldkomponente entsprechenden Stelle befindliche LED ein, was die Auswertung erleichtert.

Die Anzeigeeinheiten 10 und 11 können auch andere Arten von Anzeigegeräten sein, z.B. Flüssigkeitskristalldisplays oder Zeigermeßgeräte.

Das arbeitende Gerät nimmt, wenn es in eine entsprechende Stellung gebracht wird, zwei im Raum einen Winkel von 90° miteinander einschließende Feldkomponenten des von dem Netz induzierten Feldes auf. In einer zweckmäßigen Stellung des Gerätes nimmt der induktive Meßfühler 1 eine vertikale, der induktive Meßfühler 2 eine waagerechte Stellung ein, d.h. der erstere mißt die vertikale, der letztere die waagerechte Komponente. Die der Größe der Komponenten entsprechenden Signale werden getrennt voneinander aufgearbeitet: mit den Vorfiltergliedern werden die Signale mit der Grundschwingungsfrequenz ausgeschlossen, die Signale mit der Frequenz der Oberschwingung werden verstärkt, die Schwingung mit der zu messenden Frequenz wird mit einem Filter abgetrennt und gleichgerichtet. Das zu der Größe der waagerechten Komponente proportionale Gleichspannungssignal wird einesteils an der zweiten Anzeigeeinheit 11 sichtbar gemacht, andernteils wird das gleiche Gleichspannungssignal in der quotientenbildenden Einheit 9 mit dem zu der Größe der vertikalen Komponente proportionalen Signal verglichen, und das Verhältnis der beiden Signale erscheint an der ersten Anzeigeeinheit 10.

Bei der Anwendung des Gerätes geht man die Linienführung der Leitung ab und mißt entweder kontinuierlich, oder in bestimmten Abständen, z.B. an jeder Wegkreuzung, durch Einstellen des einen induktiven Meßfühlers in die vertikale und des anderen induktiven Meßfühlers in die waagerechte Stellung in zu der Linienführung senkrechter Ebene das Verhältnis der Komponenten der ausgewählten Oberschwingung und die Größe der waagerechten Komponente. Die Messung wird so lange fortgesetzt, bis sich der Wert der waagerechten Komponente bezogen auf den vorher gemessenen Wert sprungartig ändert. In dem so eingegrenzten Abschnitt werden die Messungen kontinuierlich oder in kürzeren Abständen vorgenommen und diejenige Stelle gesucht, an der sich die waagerechte Komponente und das erwähnte Verhältnis gleichzeitig ändern. An dieser Stelle wird der Grund des Erdschlusses durch Augenschein, durch Messung des Widerstandes der Isolation oder auf andere bekannte Weiss bestimmt.

In Fig. 2 ist eine bevorzugte Ausführungs-form der zweiten Variante des erfindungsgemäßen Gerätes dargestellt.

Das Gerät hat zwei induktive Meßfühler 1 und 2, an die sich über in der Zeichnung nicht dargestellte Vorfilterglieder in Reihe geschaltet die Verstärker 13 bzw. 14, die Filter 5 bzw. 6, Gleichrichter 7 bzw. 8 und die Anzeigeeinheiten 10 bzw. 11 in der Weise anschließen, daB die beiden signalverarbeitenden Ketten völlig voneinander getrennt sind. Das Gerät ist mit einer automatischen, verstärkungsregelnden Rückkopplung versehen.

Die induktiven Meßfühler 1, 2 entsprechen den im Zusammenhang mit Fig. 1 beschriebenen Meßfühlern; sie sind so fixiert, daß sie miteinander einen Winkel von 90° einschließen. Ähnlich wie bei dem bereits beschriebenen Gerät wird da Vorfilterglied von einem entsprechend geschalteten kapazitiven Element, z.B. einem Kondensator, gebildet, das zusammen mit dem induktiven Meßfühler einen die Signale mit der Frequenz der Grundschwingung ausschließenden Schwingkreis darstellt.

Die Verstärkers 13 und 14 haben eine hohe eingangsimpedanz nd können in einem breiten Bereich ausgesteuert werden. Ihre Verzerrung ist gering, und sie sind mit einem zweiten, zur Verstärkungssteuerung dienenden Eingang versehen. Ihr Verstärkungsfaktor ist auf den gleichen Wert eingestellt und kann so verstellt werden, daß die Übereinstimmung bestehen bleibt. Die Verstärker 13 und 14 können, ähnlich wie bei der ersten Variante des Gerätes, mit Bandsperren versehen und als ein einziger Mehrkanalverstärker ausgeführt sein.

Die Filter 5 bzw. 6 sind so abgestimmt, daß ihre Betriebsfrequenz der zu messenden Frequenz entspricht. Sie verfügen über einen Betriebsfrequenzbereich, dessen Breite auch die Erfassung von sich durch Frequenzschwankungen ergebenden Frequenzen ermöglicht. Vorzugsweise handelt es sich um aktive, mit einem Doppel-T-Glied rückgekoppelte Filter.

Die Gleichrichter 7 bzw. 8 sind Signalwandler mit hoher Linearität und kleinem Unempfindlichkeitsbereich.

Die aus den induktiven Meßfühlern 1 bzw. 2, den Vorfiltergliedern, den Verstärkern 13 und 14, den Filtern 5 bzw. 6 und den Gleichrichtern 7 bzw. 8 bestehenden signalverarbeitenden Ketten weisen Betriebsparameter auf, die gewährleisten, daß in den Ketten durch Feldkomponenten gleicher Stärke Gleichspannung gleicher Stärke geliefert wird.

Die verstärkungsregelnde Rückkopplung wird dadurch realisiert, daß der Ausgang eines der Gleichrichter, insbesondere der des dem induktiven Meßfühler 1 für die vertikale Feldkomponente zugeordneten Gleichrichters, verzweigt ist und der eine Zweig mit dem Eingang einer steuersignalbildenden Einheit 12 verbunden ist. Der Ausgang der steuersignalbildenden Einheit 12 ist einesteils an den Steuereingang des in der gleichen signalaufarbeitenden Kette befindlichen Verstärkers 13, andernteils an den zweiten Eingang, den Steuereingang, des in der anderen Kette befindlichen Verstärkers 14 rückgekoppelt.

Die Rückkopplung ist so eingestellt, daß sich die Verstärkung des an den induktiven Meßfühler 1 für die vertikale Feldkomponente angeschlossenen Verstärkers 13 so lange ändert, bis der Ausgangspegel des Gleichrichters 7 der gewählten Einheit entspricht. Auf diese Weise wird die zu der signalverarbeitenden Kette gehörende Anzeigeeinheit 10 zu einer Einheitsanzeige.

Die Verstärkung des in die sich an den anderen induktiven Meßfühler 2 anschließenden Kette geschalteten Verstärkers 14 wird ebenfalls von dem Ausgangssignal der steuersignalbildenden Einheit 12 gesteuert. Da die Betriebsparameter beider signalverarbeitender Ketten in dem zu messenden Frequenzbereich identisch sind, wird an der Anseigeeinheit 11 der für die waagerechte Komponente gemessene Wert in Einheiten des für die vertikale Komponente gemessenen Wertes ausgedrückt angezeigt.

Bei dieser Ausführungsform können die Anzeigeeinheiten einfacher gestaltet werden. Es genügt, wenn nur die eine Anzeigeeinheit, die Anzeigeeinheit 11, mit einem Signalwandler und an dessen Ausgang mit LED-Anzeigegliedern versehen ist; die anderen Anzeigeeinheit 10 kann von einer entsprechend angeordneten LED gebildet werden.

Ähnlich wie das in Fig. 1 dargestellte Gerät nimmt auch das in Fig. 2 dargestellte Gerät, in entsprechende Stellung gebracht und in Funktion gestetzt, die vertikale und die waagerechte Komponente des Felds gleichzeitig und getrennt voneinander auf. Die aufgenommenen Signal werden vorgefiltert, verstärkt, gefiltert und gleichgerichtet, und der Wert der vertikalen Komponente wird als Einheit, der Wert der waagerechten Komponente in dieser Einheit ausgedrückt angezeigt.

Was die Wahl der Meßorte betrifft, so geht man ähnlich vor wie bereits beschrieben. Die Anzeigeeinheiten können z.B. auch mit einer Vorsatzstufe versehene Flüssigkeitskristallanzeigen oder sonstige, für den Zweck geeignete Mittel sein.

**Patentansprüche**

1. Verfahren zur Erdschlußortung an Starkstrom-Freileitungsnetzen, bei dem der Betrieb des Netzes kontinuierlich aufrechterhalten wird und entlang der Linienführung des Netzes stellenweise oder kontinuierlich die Größe des von einer bestimmten Oberschwingung des Netzstromes erregten Magnetfeldes gemessen wird, dadurch gekennzeichnet, daß die Größe der waagerechten Komponente und die Größe einer mit dieser waagerechten Komponente im Raum einen Winkel größer Null einschließenden zweiten Komponente des Magnetfeldes einzeln, jedoch gleichzeitig gemessen werden, dabei durch Beobachten des Verhältnisses der Größen der Komponenten zueinander das Vorliegen des Erdschlusses festgestellt wird und der Ort des Erdschlusses an der Stelle einer sprunghaften Änderung des Verhältnisses der Komponenten und der Größe der waagerechten Komponente lokalisiert wird.

2. Verfahren nach Anspruch 1, dadurch gekennzeichnet, daß als zweite Komponente die vertikale Komponente des Magnetfeldes gemessen wird.

3. Gerät zur Erdschlußortung an Starkstrom-Freileitungsnetzen, mit einem zur Aufnahme einer Komponente des von dem Netzstrom induzierten Magnetfeldes dienenden Meßfühler (1), der über Folgeglieder aus einem Signale mit der Frequenz der Grundschwingung des Magnetfeldes ausschließenden Vorfilterglied, einem Verstärker (3), einem auf eine bestimmte zu messende Oberschwingung des Magnetfeldes abgestimmten Filter (5) und einem Gleichrichter (7) an eine Anzeigeeinheit (10) angeschlossen ist, dadurch gekennzeichnet, daß ein im Winkel größer Null, zweckmäßigerweise 90°, zu dem Meßfühler (1) ausgerichteter zweiter Meßfühler (2) mit diesem gesondert zugeordneten Folgegliedern aus einem Signale mit der Frequenz der Grunfschwingung des Magnetfeldes ausschließenden Vorfilterglied, einem Verstärker (4), einem auf die zu messende Oberschwingung des Magnetfeldes abgestimmten Filter (6) und einem Gleichrichter (8) vorgesehen ist, daß die Verstärkungsfaktoren der beiden Verstärker (3, 4) gleich sind, daß der Ausgang des dem einen Meßfühler (1) zugeordneten Gleichrichters (7) an den einen Eingang einer quotientenbildenden Einheit (9) angeschlossen ist, an deren Ausgang die Anzeigeeinheit (10) angeschlossen ist, und daß der Ausgang des dem anderen Meßfühler (2) zugeordneten Gleichrichters (8) einerseits an den anderen Eingang der quotientenbildenden Einheit (9) und andererseits an eine zweite Anzeigeeinheit (11) angeschlossen ist.

4. Gerät zur Erdschlußortung an Starkstrom-Freileutungsnetzen, mit einem zur Aufnahme einer Komponente des von dem Netzstrom induzierten Magnetfeldes dienenden Meßfühler (1), der über Folgeglieder aus einem Signale mit der Frequenz der Grundschwingung des Magnetfeldes ausschließenden Vorfilterglied, einem Verstärker (13), einem auf eine bestimmte zu messende Oberschwingung des Magnetfeldes abgestimmten Filter (5) und einem Gleichrichter (7) an eine Anzeigeeinheit (10) angeschlossen ist, dadurch gekennzeichnet, daß ein im Winkel größer Null, zweckmäßigerweise 90°, zu dem Meßfühler (1) ausgerichteter zweiter Meßfühler (2) mit diesem gesondert zugeordneten Folgegliedern aus einem Signale mit der Frequenz der Grundschwingung des Magnetfeldes ausschließenden Vorfilterglied, einem Verstärker (14), einem auf die zu messende Oberschwingung des Magnetfeldes abgestimmten Filter (6) und einem Gleichrichter (8) vorgesehen ist, daß die Verstärkungsfaktoren der beiden Verstärker (13, 14) gleich sind, daß der Ausgang des dem einen Meßfühler (1) zugeordneten Gleichrichters (7) einerseits mit dem Eingang der Anzeigeeinheit (10) verbunden und andererseits unter Zwischenschaltung einer steuersignalbildenden Einheit (12) an die Steuereingänge der beiden Verstärker (13, 14) rückgekoppelt ist und daß der Ausgang des dem anderen Meßfühler (2) zugeordneten Gleichrichters (8) an einen zweite Anzeigeeinheit (11) angeschlossen ist.

5. Gerät nach Anspruch 3 oder 4, dadurch gekennzeichnet, daß die Verstärker (3, 4; 13, 14) mit einer Bandsperre versehen sind.

6. Gerät nach Anspruch 3 oder 4, dadurch gekennzeichnet, daß die auf die bestimmte Oberschwingung abgestimmten Filter (5, 6) aktive Filter, insbesondere ein Doppel-T-Glied oder ein mehrfach rückgekoppeltes Filterglied aufweisende Filter sind.

7. Gerät nach einem der Ansprüche 3 bis 6, dadurch gekennzeichnet, daß die Anzeigeeinheiten (10, 11) an ihrem Ausgang einen eine Spannung erzeugenden Signalwandler und an dessen Ausgang LED-Anzeigeglieder aufweisen.

8. Gerät nach einem der Ansprüche 3 bis 7, dadurch gekennzeichnet, daß die Meßfühler (1, 2) als induktive Meßfühler ausgebildet sind und daß an ihren Ausgang ein kapazitives Element angeschlossen ist, das mit dem induktiven Meßfühler (1, 2) zusammen einen die Signale mit der Frequenz der Grundschwingung ausschließenden Schwingkreis bildet.

**Revendications**

1. Procédé de repérage de l'emplacement d'une mise à la terre intempestive dans les réseaux de conducteurs aériens de courant de forte intensité, dans lequel l'exploitation du réseau est poursuivie de manière continue, et dans lequel on mesure en des endroits distincts ou de manière continue, le long des conducteurs, la valeur du champ magnétique engendré par une harmonique déterminée du courant du réseau, caractérisé en ce qu'on mesure séparément, mais simultanément la valeur de la composante horizontale et la valeur d'une seconde composante délimitant dans l'espace, avec ladite composante horizontale, un angle supérieur à zéro, en ce qu'en observant le rapport entre les valeurs des composantes, on constate l'existence d'une mise à la terre, et en ce qu'on repère l'emplacement de la mise à la terre à l'endroit où le rapport des composantes et la valeur de la composante horizontale changent brusquement.

2. Procédé selon la revendication 1, caractérisé en ce qu'en guise de seconde composante, on mesure la composante verticale du champ magnétique.

3. Appareil pour repérer l'emplacement d'une mise à la terre intempestive dans des réseaux de conducteurs aériens de courant de forte intensité, comprenant une sonde de mesure (1) servant à recevoir une composante du champ magnétique induit par le courant du réseau et reliée à une unité d'affichage (10) par l'intermédiaire d'organes montés en série et constitués par un organe de préfiltrage écartant les signaux dont la fréquence est celle des oscillations fondamentales du champ magnétique, un amplificateur (3), un filtre (5) accordé à une harmonique déterminée du champ magnétique susceptible d'être mesurée, et un redresseur (7), caractérisé en ce qu'il comporte un seconde sonde de mesure (2) orientée par rapport à la première sonde de mesure (1) un angle supérieur à zéro, avantageusement un angle de 90°, et associée séparément à des organes montés en série et constitués par un organe de préfiltrage écartant les signaux dont la fréquence est celle des oscillations du champ magnétique, un amplificateur (4), un filtre (6) accordé à l'harmonique à mesurer du champ magnétique, et un redresseur (8), en ce que les coefficients d'amplifiation des deux amplificateurs (3, 4) sont égaux, en ce que la sortie du redresseur (7) associé à la première sonde de mesure (1) est reliée à l'une des entrées d'une unité productrice de quotients (9) dont la sortie est reliée à l'unité d'affichage (10), et en ce que la sortie du redresseur (8) associé à l'autre sonde de mesure (2) est reliée, d'une part, à l'autre entrée de l'unité productrice de quotients (9) et, d'autre part, à une seconde unité d'affichage (11).

4. Appareil pour repérer l'emplacement d'une mise à terre intempestive dans des réseaux de conducteurs aériens de courant de forte intensité, comprenant une sonde de mesure (1) servant à recevoir une composante du champ magnétique induit par le courant du réseau et reliée à une unité d'affichage (10) par l'intermédiaire d'organes montés en série et contsitués par un organe de préfiltrage écartant les signaux dont la fréquence est celle des oscillations fornda- mentales du champ magnétique, un amplificateur (13), un filtre (5) accordé à une harmonique déterminée du champ magnétique susceptible d'être mesurée, et un redresseur (7), caractérisé en ce qu'il comporte une seconde sonde de mesure (2) orientée par rapport à la première sonde de mesure (1) selon un angle supérieur à zéro, avantageusement un angle de 90°, et associée séparément à des organes montés en série et constitués par un organe de préfiltrage écartant les signaux dont la fréquence est celle des oscillations fondamentales du champ magnétique, un amplificateur (14), un filtre (6) accordé à l'harmonique à mesurer du champ magnétique, et un redresseur (8), en ce que les coefficients d'amplification des deux amplificateurs (13, 14) sont égaux, en ce que la sortie du redresseur (7) associé à la première sonde de mesure (1) est, d'une part, reliée à l'entrée de l'unité d'affichage (10) et, d'autre part, accouplée rétroactivement par l'intermédiaire d'une unité (12) produisant des signaux de commande, aux entrées de commande des deux amplificateurs (13, 14), et en ce que la sortie du redresseur (8) associé à l'autre sonde de mesure (2) est reliée à une seconde unité d'affichage (11).

5. Appareil selon la revendication 3 ou 4, caractérisé en ce qaue les amplificateurs (3, 4; 13, 14) comportent un filtre de bande.

6. Appareil selon la revendication 3 ou 4, caractérisé en ce que les filtres (5, 6) accordés à l'harmonique déterminée sont des filtres actifs, notamment des filtres comportant un composant à double T ou un composant filtrant à accouplement rétroactif multiple.

7. Appareil selon une des revendications 3 à 6, caractérisé en ce que les unités d'affichage (10, 11) comportent à leur sortie un convertisseur de signaux qui produit une tension et à la sortie duquel sont prévus des organes LED.

8. Appareil selon une quelconque des revendications 3 à 7, caractérisé en ce que les sondes de mesure (1, 2) sont réalisées sous forme de sondes de mesure à induction, et en ce qu'un élément capacitif relié à leur sortie forme, en combinaison avec la sonde de mesure à induction (1, 2), un circuit oscillatoire écartant les signaux dont la fréquence est celle des oscillations fondamentales.

**Claims**

1. Method of locating earth faults in overhead power line networks, in which operation of the mains is continuously maintained and the magnitude of the magnetic field energised by a specific higher harmonic of the mains current is measured continuously or at random locations, characterised in that the magnitude of the horizontal component and that of a second component of the magnetic field which subtends with this horizontal component an angle greater than nil in the space is individually but simultaneously measured, the presence of an earth fault being established by observing the relationship of the values of the components in relation to one another, the site of the earth fault being located where there is an abrupt change in the ratio of the components and the value of the horizontal component.

2. Method according to Claim 1, characterised in that the vertical component of the magnetic field is measured as the second component.

3. Device for earth fault location in overhead power lines having, serving to record a component of the magnetic field induced by the mains current, a measuring sensor (1) which is connected to a display unit (10) via sequential elements comprising a pre-filter member for excluding signals having the frequency of the basic harmonic of the magnetic field, an amplifier (3), a filter (5) tuned to a specific higher harmonic of the magnetic field which is intended to be measured and a rectifier (7), characterised in that there is provided, orientated at an angle greater than nil and expediently 90° to the measuring sensor (1), a second measuring sensor (2) having sequential elements associated separately therewith, comprising a pre-filter member excluding signals having the frequency of the basic harmonic of the magnetic field, an amplifier (4), a filter (6) tuned to the higher harmonic of the magnetic field which is intended to be measured, and a rectifier (8), and in that the amplification factors of the two amplifiers (3, 4) are equal and in that the output of the rectifier (7) associated with one measuring sensor (1) is connected to one input of a quotient forming unit (9) to the output of which the display unit (10) is connected, and in that the output of the rectifier (8) associated with the other measuring sensor (2) is connected on the one hand to the other input of the quotient forming unit (9) and on the other to a second display unit (11).

4. A device for earth fault location in overhead power lines, having, serving to record a component of the magnetic field induced by the mains current, a measuring sensor (1) which is connected to a display unit (10) via sequential elements comprising a pre-filter member for excluding signals having the frequency of the basic harmonic of the magnetic field, an amplifier (13), a filter (5) tuned to a specific higher harmonic of the magnetic field which is intended to be measured and a rectifier (7), characterised in that there is provided, orientated at an angle greater than nil and expediently 90° to the measuring sensor (1), a second measuring sensor (2) having sequential elements associated separately therewith, comprising a pre-filter member excluding signals having the frequency of the basic harmonic of the magnetic field, an amplifier (14), a filter (6) tuned to the higher harmonic of the magnetic field which is intended to be measured, and a rectifier (8), and in that the amplification factors of the two amplifiers (13, 14) are equal and in that the output of the rectifier (7) associated with one measuring sensor (1) is on the one hand connected to the input of the display unit (10) and is on the other, through an interposed control signal forming unit (12) coupled back to the control inputs of the two amplifier (13, 14) and in that the output of the rectifier (8) associated with the other measuring sensor (2) is connected to a second display unit (11).

5. Device according to Claim 3 or 4, characterised in that the amplifiers (3, 4; 13, 14) are provided with a bandrejection filter.

6. Device according to Claim 3 or 4, characterised in that the filters (5, 6) tuned to the specific higher harmonic are active filters, being in particular filters having a double-T member or a multiple feedback filter member.

7. Device according to one of the Claims 3 to 6, characterised in that the display units (10, 11) have at their output a signal converter generating a voltage and LED display elements at the output thereof.

8. Device according to one of Claims 3 to 7, characterised in that the measuring sensors (1, 2) are constructed as inductive measuring sensors and in that there is connected to their output a capacitative element which, together with the inductive measuring sensor (1, 2) forms an oscillating circuit which excludes the signals which have the same frequency as the basic harmonic.

**0 069 790**

Fig.1

Fig.2